# EUROPÄISCHE PATENTSCHRIFT

(11) **EP 2 415 088 B1**
(45) Veröffentlichungstag und Bekanntmachung des Hinweises auf die Patenterteilung: **25.03.2015**
(21) Anmeldenummer: 10718899.7
(22) Anmeldetag: 31.03.2010
(51) Int. Cl.: H01L 35/30, F01N 5/02

(54) **THERMOELEKTRISCHE GENERATOREINHEIT**
THERMOELECTRIC GENERATOR UNIT
DISPOSITIF GÉNÉRATEUR THERMOÉLECTRIQUE

(30) Priorität: 02.04.2009 AT 5262009; 09.07.2009 AT 10762009
(43) Veröffentlichungstag der Anmeldung: 08.02.2012
(73) Patentinhaber: AVL List GmbH, 8020 Graz (AT)
(72) Erfinder: SALZGEBER, Kurt, A-8301 Lassnitzhöhe (AT)
(74) Vertreter: Babeluk, Michael
(86) Internationale Anmeldenummer: PCT/EP2010/054369
(87) Internationale Veröffentlichungsnummer: WO 2010/112571

(56) Entgegenhaltungen:
- EP-A2- 1 505 662
- FR-A1- 2 427 690
- US-A- 3 451 858
- US-A- 5 031 689

## Beschreibung

Die Erfindung betrifft eine thermoelektrische Generatoreinheit, mit zumindest einem thermoelektrischen Modul, welches in einer sandwichartigen Anordnung an einer Seite einen Abgaswärmetauscher und an der gegenüberliegenden Seite einen Kühlmittelwärmetauscher aufweist, wobei der Abgas- und der Kühlmittelwärmetauscher als Flachrohre ausgeführt sind, deren Flachseiten jeweils über seitliche Wandabschnitte verbunden sind.

Thermoelektrische Generatoren (TEG) zur Erzeugung von elektrischer Energie unter Ausnützung einer Temperaturdifferenz, beispielweise im Zusammenhang mit Kraftfahrzeugen, bei welchen die Abgaswärme einer Brennkraftmaschine ausgenützt wird, sind bereits seit längerer Zeit bekannt. Das thermoelektrische Modul derartiger Generatoreinheiten besteht aus einer Reihe von p- und n-dotierten Schenkeln, die an deren Enden mit elektrischen Kontakten versehen sind. Dabei wird der Seebeck-Effekt ausgenützt, bei welchem die Temperaturdifferenz zwischen zwei Enden (einem Hochtemperaturabschnitt und einem Niedrigtemperaturabschnitt) eines Metalls oder eines Halbleiterteils eine Potentialdifferenz hervorruft.

Beispielsweise ist aus der DE 10 2005 005 077 A1 ein thermoelektrischer Generator für eine Brennkraftmaschine bekannt geworden, der an einen Abgaskanal angeschlossen ist. Der Generator weist ein heißes Teil auf, welches an dem Abgaskanal angeordnet ist und ein kaltes Teil (Kühlmittelwärmetauscher), welches mit dem Kühlkreislauf der Brennkraftmaschine in Verbindung steht. Die einzelnen Teile des thermoelektrischen Generators sind konzentrisch um den Abgaskanal angeordnet, und werden durch einzelne außen umlaufende, kreisförmige Halteteile an die Oberfläche des Abgaskanals angepresst, wobei zwischen den Kühlmittelwärmetauscherelementen und den kreisförmigen Halteteilen elastische Elemente angeordnet sind, um die thermoelektrischen Generatorelemente in einem Zustand zu halten, in welchem sie zwischen den heißen Teilen und den kalten Teilen des Generators derart eingepresst sind, dass eine durch unterschiedliche thermische Ausdehnung der einzelnen Komponenten hervorgerufene Relativbewegung ermöglicht wird. Das Problem besteht also darin, eine Abfolge bestehend aus Abgaswärmetauscher, thermoelektrischem Modul und Kühlmittelwärmetauscher möglichst gleichmäßig zusammenzupressen, so dass ein guter thermischer Kontakt gewährleistet ist, wobei allerdings Spannungen aufgrund unterschiedlicher Wärmeausdehnung der einzelnen Bestandteile möglichst gering gehalten werden müssen, um Beschädigungen zu vermeiden.

Aus der DE 10 2005 051 309 A1 ist in diesem Zusammenhang ein thermoelektrischer Generator bekannt geworden, der einen flächigen Abgaswärmetauscher aufweist, wobei zumindest zwei thermoelektrische Elemente vorgesehen sind und der Abgaswärmetauscher sandwichartig zwischen den beiden thermoelektrischen Elementen angeordnet ist. Die Baueinheit wird außen durch zwei Kühlmittelwärmetauscher abgeschlossen, wobei die Baugruppe aus Abgaswärmetauscher und thermoelektrischen Elementen sandwichartig zwischen den beiden Kühlmittelwärmetauschern angeordnet ist. Die Kühlmittelwärmetauscher weisen nach außen zeigende zungenförmige Befestigungslaschen auf, die mit Durchgangsöffnungen versehen sind. Zusätzlich ist noch eine zentrale Bohrung durch alle Bauelemente der Generatoreinheit vorgesehen, wobei zur Flächenpressung und Fixierung der einzelnen Elemente sowohl in den Durchgangsöffnungen, als auch in der zentralen Bohrung Schrauben mit Kontermuttern vorgesehen sind. Anstelle der Schraubverbindung können auch Federklammern verwendet werden.

Des weiteren ist auch aus der US 2006/0157102 A1 ein System zur Nutzung der Abfallwärme, beispielsweise aus einer Brennkraftmaschine bekannt, welche in einem flachen Aufbau einen zentralen Hochtemperatur-Wärmetauscher mit einer innen liegenden Lamellenstruktur aufweist, wobei an beiden Seiten thermoelektrische Module angelagert sind. Die Außenseite beider thermoelektrischer Module wird jeweils von einem Niedertemperatur-Wärmetauscher thermisch kontaktiert, wobei auch der Niedertemperatur-Wärmetauscher eine innen liegende Lamellenstruktur aufweist. Das heiße Abgas im Hochtemperatur-Wärmetauscher und das Kühlmedium im Niedertemperatur-Wärmetauscher werden parallel jedoch in entgegengesetzten Richtungen durch die thermoelektrische Generatoreinheit geführt.

Aus der JP 2007-221895 ist gemäß Fig. 1 eine thermoelektrische Generatoreinheit mit thermoelektrischen Modulen bekannt, welche mit einer Seite einen Abgaswärmetauscher (high temperature heat exchanger) und mit der gegenüberliegenden Seite einen Kühlmittelwärmetauscher (low temperature heat exchanger) kontaktieren. Der Kühlmittelwärmetauscher und der Abgaswärmetauscher sind als Flachkanäle ausgeführt, wobei die einzelnen Komponenten in ebener Anordnung stapelbar und somit in platzsparender, Ausführung herstellbar sind.

Die gesamte Anordnung wird durch mehrere zweiteilige Klammerelemente zusammengehalten, wobei zum Schutz vor Korrosion ein hitzebeständiger, wasserdichter Rahmen für die TEG-Module vorgesehen ist, der in gegenüberliegende Nuten der Abgas- und Kühlmittelwärmetauscher eingesetzt ist. Weiters sind zwischen den Klammerelementen und den außen liegenden Wärmetauschern Federelemente in Form von Tellerfedern angeordnet, mit welchen der Anpressdruck justiert werden kann.

Aus der DE 15 39 330 A1 ist eine thermoelektrische Generatoreinheit mit thermoelektrischen Modulen in Form von Thermoschenkeln mit elektrischen Kontaktbrücken bekannt, welche an der Warmseite ein großvolumiges Wärmetauscherrohr kontaktieren und an der Kaltseite mit mehreren am Umfang verteilten Flachkanälen in Kontakt stehen. Die Flachkanäle sind in Richtung der Achse der Thermoschenkel elastisch verformbar um Fertigungstoleranzen und Längenänderungen aufgrund der auftretenden Temperaturunterschiede ausgleichen zu können. Die Flachkanäle werden mit bügelartigen Widerlagern und zu beiden Seiten der Flachkanäle angeordneten Schrauben am zentralen Wärmetauscherrohr befestigt.

Aufgabe der Erfindung ist es, ausgehend von den eingangs beschriebenen Vorrichtungen zur Energieerzeugung eine thermoelektrische Generatoreinheit vorzuschlagen, welche konstruktiv möglichst einfach aufgebaut ist, wobei mit einfachen Mitteln eine gleichmäßige, dauerhafte Verpressung der einzelnen Strukturelemente der Generatoreinheit erzielt werden soll.

Erfindungsgemäß wird diese Aufgabe dadurch gelöst, dass an den seitlichen Wandabschnitten zumindest der beiden außen liegenden Wärmetauscher Seitenwände befestigt sind, die die Spannkräfte für eine gleichmäßige, dauerhafte Verpressung der einzelnen Elemente der thermoelektrischen Generatoreinheit aufnehmen.

Erfindungsgemäß kann das thermoelektrische Modul mittels der die Spannkräfte aufnehmenden Seitenwände seitlich abgedichtet sein, wobei diese gleichzeitig eine Spann- und eine Dichtfunktion erfüllen und das thermoelektrische Modul nach außen glatt und eben abschließen. Zusammen mit front- und rückseitigen Stirnwänden der Generatoreinheit bilden die Seitenwände einen im Wesentlichen geschlossenen Innenraum, in welchem das thermoelektrische Modul geschützt angeordnet ist.

Um temperaturabhängige Spannungen, insbesondere beim Hochfahren oder Abschalten der thermoelektrische Generatoreinheit, ausgleichen zu können, ist es wichtig, die Spannkräfte elastisch abzufedern.

Gemäß einer ersten Variante der Erfindung ist daher an zumindest einer Kontaktfläche zwischen dem thermoelektrischen Modul und dem Abgaswärmetauscher oder dem Kühlmittelwärmetauscher zumindest ein Federelement, beispielsweise ein Wellfederelement oder ein Blattfederelement, angeordnet. Gemäß einer zweiten Variante der Erfindung kann zumindest eine der dem thermoelektrischen Modul zugewandten Flachseiten des Abgaswärmetauschers oder des Kühlmittelwärmetauschers in Richtung des thermoelektrischen Moduls elastisch vorgespannt sein. Beispielsweise kann die elastisch vorgespannte Seite im unverbauten Zustand eine näherungsweise zylindrische Auswölbung in Richtung des thermoelektrischen Moduls aufweisen, deren Kontur im verbauten Zustand flach gepresst ist und auf diese Weise die TEG-Elemente gleichmäßig anpresst.

Die im unverbauten Zustand erforderliche Kontur der näherungsweise zylindrischen (prismatischen) Wand kann entsprechend der Biegebalkentheorie für konstante Streckenlast und mäßiger Verdrehsteifigkeit an den Auflagepunkten ermittelt werden, um eine Anpressung der TEG-Module im Bereich von 0,1 N/mm² bis 5 N/mm² zu erreichen. Ergänzend kann die unverspannte Kontur mittels Finite Element Analyse des TEG-Moduls hinsichtlich gleichmäßiger Anpressung aller TEG-Schenkel optimiert werden.

Schließlich können in einer dritten Variante der Erfindung die Seitenwände der thermoelektrischen Generatoreinheit als Zugfedern ausgebildet sein. Es ist auch möglich, mehrere der aufgezählten Varianten zur flexiblen Pressung gleichzeitig einzusetzen.

Gemäß vorliegender Erfindung können die Seitenwände der Generatoreinheit auf unterschiedliche Art kraftschlüssig und dichtend an den seitlichen Wandabschnitten der Wärmetauscher befestigt werden, nämlich durch Schweißen, Kleben, oder Löten, durch eine Niet- oder Schraubverbindung bzw. durch eine Rast-oder Schnappverbindung.

Die Erfindung wird im Folgenden anhand von Zeichnungen näher erläutert. Es zeigen:
- Fig. 1: eine erfindungsgemäße thermoelektrische Generatoreinheit in einer Schnittdarstellung in unverbautem Zustand;
- Fig. 2: die Generatoreinheit gemäß Fig. 1 in verbautem Zustand;
- Fig. 3: und Fig. 4 eine Variante der erfindungsgemäßen Generatoreinheit gemäß Fig. 1 und Fig. 2 in unverbautem bzw. verbautem Zustand;
- Fig. 5: bis Fig. 7 weitere Varianten der erfindungsgemäßen thermoelektrischen Generatoreinheit in unverbautem Zustand in einer Schnittdarstellung gemäß Fig. 1;
- Fig. 8: eine Variante der erfindungsgemäßen Generatoreinheit in verbautem Zustand in einer Schnittdarstellung gemäß Fig. 2;
- Fig. 9: eine dreidimensionale Teilansicht einer erfindungsgemäßen thermoelektrischen Generatoreinheit;
- Fig. 10: eine Explosionsdarstellung der Generatoreinheit gemäß in Fig. 9;
- Fig. 11: und Fig. 12 eine vergrößerte Schnittdarstellung der Generatoreinheit gemäß Linie X - X in Fig. 9 in unverbautem bzw. verbautem Zustand;
- Fig. 13: und Fig. 14 eine erfindungsgemäße thermoelektrische Generatoreinheit in einer Schnittdarstellung bestehend aus einem Abgaswärmetauscher und zwei Kühlmittelwärmetauschern in unverbautem sowie verbautem Zustand;
- Fig. 15: eine weitere Variante der erfindungsgemäßen thermoelektrischen Generatoreinheit in einer Draufsicht;
- Fig. 16: die Generatoreinheit gemäß Fig. 15 in einer Stirnansicht; sowie
- Fig. 17: die Generatoreinheit in einer Schnittdarstellung gemäß Linie Y - Y in Fig. 15.

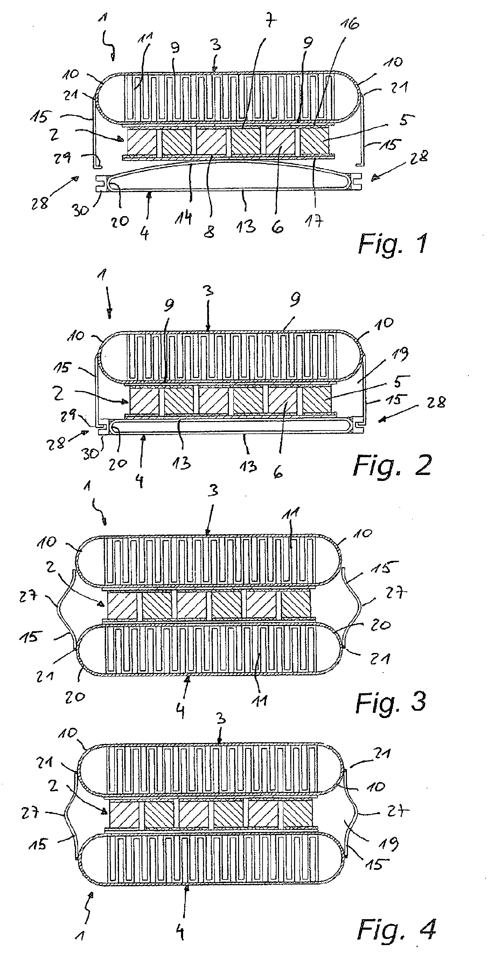

Die in den Fig. 1 und Fig. 2 dargestellte thermoelektrische Generatoreinheit 1 weist ein thermoelektrisches Modul 2 auf, welches mit einer Seite einen Flachrohr-Abgaswärmetauscher 3 und mit der anderen Seite einen Flachrohr-Kühlmittelwärmetauscher 4 thermisch kontaktiert.

Das thermoelektrische Modul 2 besteht in bekannter Weise aus n- und p-dotierten Schenkeln 5, 6 (N- und P-Legs), die an den Enden mit elektrischen Kontakten 7, 8 versehen sind und zusammengeschaltete Peltierelemente ergeben, deren nach außen führende Anschlussleitungen hier nicht dargestellt sind.

Der Abgaswärmetauscher 3 weist gegenüberliegende Flachseiten 9 auf, die über seitliche Wandabschnitte 10, die gekrümmt bzw. abgerundet ausgeführt sein können, verbunden sind. Im Bereich der gegenüberliegenden Flachseiten 9 sind Lamellen 11, vorzugsweise ein einstückiger Lamellenzug, angeordnet, welche zu den Flachseiten 9 im Wesentlichen rechtwinkelig angeordnet sind und der Maximierung des gasseitigen Wärmeübergangs dienen, wobei gleichzeitig eine Versteifung des Flachrohrs 3 erzielt wird.

Der Kühlmittelwärmetauscher 4 weist gegenüberliegende Flachseiten 13 auf, die über beispielsweise abgerundete, seitliche Wandabschnitte 20 verbunden sind, wobei die dem thermoelektrischen Modul 2 zugewandte Wand im verbauten Zustand elastisch vorgespannt ist. Gemäß Fig. 1 weist die dem thermoelektrischen Modul 2 zugewandte Wand 13 des Flachkanals 4 im unverbauten Zustand eine näherungsweise zylinderartige (prismatische) Auswölbung 14 auf, deren Kontur im verbauten Zustand (siehe Fig. 2) flach gepresst ist. Die Kontur der Auswölbung 14 ist derart optimiert, dass im zusammengebauten Zustand eine gleichmäßige Verpressung der N- und P-Legs 5, 6 erreicht werden kann.

Bei der Herstellung wird die Gesamtstruktur gemäß Fig. 1, mit bereits angeschweißten Seitenwänden 15 (siehe Schweißnaht 21 im gekrümmten Wandabschnitt 10) in einer geeigneten Vorrichtung zusammengepresst, bis die Endbereiche der Seitenwände 15 an den Wandabschnitten 20 des Kühlmittelwärmetauschers 4 reichen und eine Rastverbindung 28 einschnappt, die aus einem Steg 29 an den Seitenwänden 15 und einer im Wandabschnitt 20 befestigten Nutleiste 30 besteht. Die Schnappverbindung 28 kann beispielsweise mittels Dichtmasse oder Klebstoff abgedichtet sein. Wie bei der Ausführung gemäß Fig. 3 und Fig. 4 können die Seitenwände 15 auch mit beiden Wandabschnitten 10 und 20 verschweißt sein. Es entsteht eine kompakte, geschlossene Einheit, in der das thermoelektrische Modul 2 geschützt vorliegt, die nach außen ebene Begrenzungsflächen aufweist und daher problemlos und platzsparend in Kraftfahrzeuge eingebaut werden kann.

Zur Reibwertminderung und Verbesserung der thermischen Kontaktierung zwischen dem Abgaswärmetauscher 3 und dem thermoelektrischen Modul 2 ist eine Gleitschicht 16, beispielsweise eine Karbonfolie oder eine MoS₂-Beschichtung vorgesehen. Weiters ist zur Verbesserung der thermischen Kontaktierung zwischen dem thermoelektrischen Modul 2 und dem Kühlmittelwärmetauscher 4 eine Kontaktschicht 17, beispielsweise eine Diamond-Like-Carbon (DLC)-Schicht angeordnet.

In den Fig. 3 und Fig. 4 ist eine Ausführungsvariante dargestellt, bei welcher die Seitenwände 15 der thermoelektrischen Generatoreinheit 1 als Zugfedern 27 ausgebildet sind. Bei der Herstellung wird die Gesamtstruktur gemäß Fig. 3, mit bereits angeschweißten Seitenwänden 15 (siehe Schweißnaht 21 im Wandabschnitt 20) in einer geeigneten Vorrichtung zusammengepresst, bis die Endbereiche der Seitenwände 15 an den Wandabschnitten 10 des Abgaswärmetauschers 3 anliegen. Danach wird der Kraftschluss mit einer Schweißnaht 21 am Wandabschnitt 10 hergestellt (siehe Fig. 4), so dass der Flachrohr-Kühlmittelwärmetauscher 4 im verbauten Zustand über vorzugsweise dicht verschweißte Seitenwände 15 mit dem Flachrohr-Abgaswärmetauscher 3 verbunden ist. Beide Wärmetauscher 3, 4 sind biegesteif ausgeführt und nehmen einen Lamellenzug 11 auf.

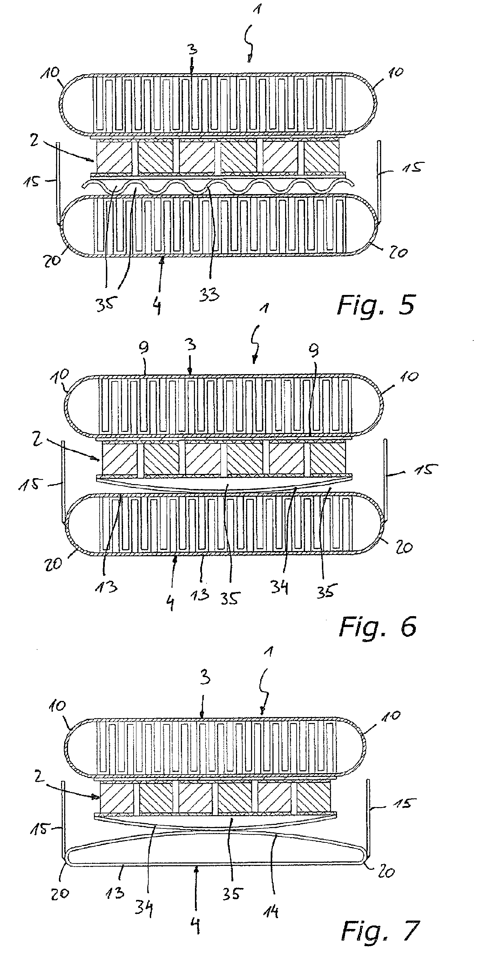

Bei den Ausführungsvarianten gemäß Fig. 5, 6 und 7 ist jeweils nur der unverbaute Zustand dargestellt, um die einzelnen Federelemente im nicht belasteten Zustand besser darstellen zu können. Die jeweils am seitlichen Wandabschnitt 20 des Kühlmittelwärmetauschers 4 angeschweißten Seitenwände 15 müssen nach dem Zusammenpressen der Generatoreinheit 1 noch an den seitlichen Wandabschnitten 10 des Abgaswärmetauschers 3 befestigt, z.B. angeschweißt, werden.

In den Varianten gemäß Fig. 5 bzw. Fig. 6 ist an einer Kontaktfläche zwischen dem thermoelektrischen Modul 2 und dem Kühlmittelwärmetauscher 4 ein Federelement, beispielsweise ein flächiges Wellfederelement 33 (Fig. 5) oder ein flächiges Blattfederelement 34 (Fig. 6), angeordnet. Zur besseren Wärmeübertragung kann in den verbleibenden, nach der Pressung vom Federelement 33, 34 aufgespannten Freiräumen 35 ein elastisches, wärmeleitendes Material, vorzugsweise eine Wärmeleitpasta, eingebracht sein.

Bei der Ausführungsvariante gemäß Fig. 7 sind zwei unterschiedliche Federelemente gleichzeitig im Einsatz. Einerseits weist der Kühlmittelwärmetauscher 4 eine federnde Auswölbung 14 auf, andererseits zusätzlich ein Blattfederelement 34 zwischen dem Kühlmittelwärmetauscher 4 und dem thermoelektrischen Modul 2.

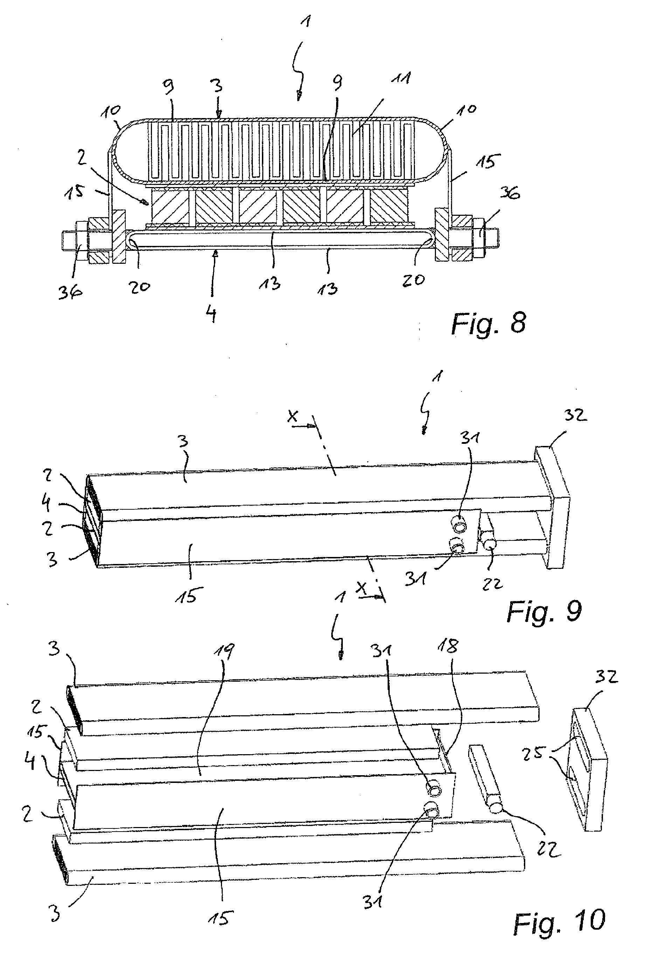

Bei der Ausführungsvariante gemäß Fig. 8 ist nur der verbaute Zustand dargestellt, bei welchem die näherungsweise zylinderartige (prismatische) Auswölbung des Flachrohr-Kühlmittelwärmetauschers 4 (siehe Fig. 1) bereits flach gepresst ist, so dass parallele Flachseiten 13 vorliegen. Die Seitenwände 15 sind hier durch eine Schraubverbindung 36 mit den seitlichen Wandabschnitten 20 des Kühlmittelwärmetauschers 4 verbunden und am Abgaswärmetauscher 3 angeschweißt. Natürlich können die Schraubverbindungen 36 auch auf der Seite des Abgaswärmetauschers 3 angeordnet sein.

Bei der in den Fig. 9 und Fig. 10 dargestellten Ausführungsvariante der (auf der linken Seite abgeschnittenen) thermoelektrischen Generatoreinheit 1 ist auf beiden Seiten des Flachrohr-Kühlmittelwärmetauschers 4 jeweils ein thermoelektrisches Modul 2 angeordnet, das jeweils einen Abgaswärmetauscher 3 thermisch kontaktiert. Die Seitenwände 15 mit den elektrischen Durchführungen 31 decken beide thermoelektrische Module 2 ab. Durch die mit den Abgaswärmetauschern 3 dicht verbundenen Seitenwände 15 und die front- und rückseitigen Stirnwände 18 des Generators (siehe Fig. 10) wird ein geschlossener Innenraum 19 gebildet, der das bzw. die thermoelektrischen Module 2 schützend aufnimmt. Der Kühlwassereinlass samt Verteilerkanal ist mit 22 gekennzeichnet, der gegenüberliegende Kühlwasserauslass ist nicht dargestellt. In einem Anschlussflansch 32 sind die Gaseintrittsöffnungen 25 für die beiden Abgaswärmetauscher 3 erkennbar.

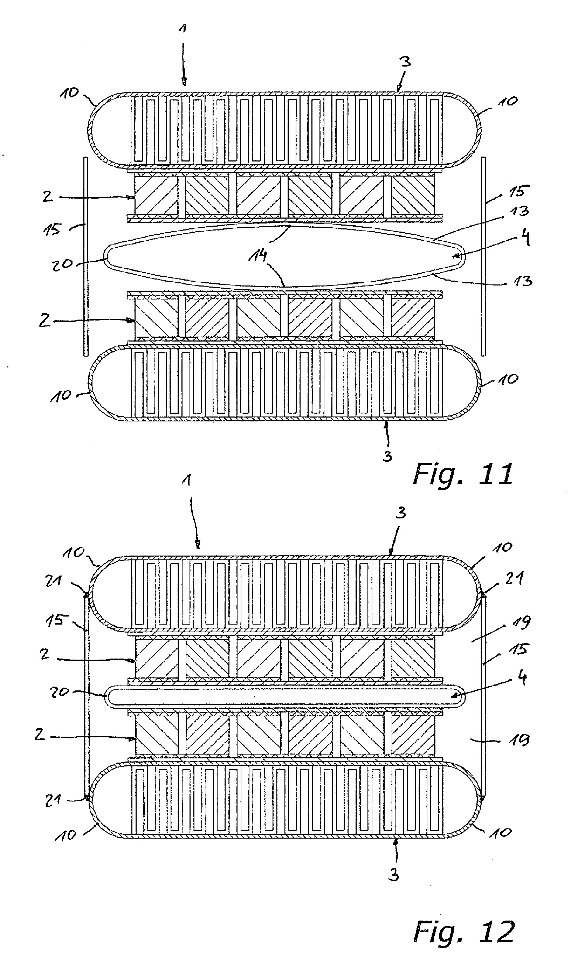

Wie aus der vergrößerten Schnittdarstellungen erkennbar, sind hier beide Wände 13 des Kühlmittelwärmetauschers 4 elastisch vorgespannt und weisen eine konvexe Wölbung 14 auf, die jeweils ein thermoelektrisches Modul 2 kontaktieren (siehe Fig. 11). Nach dem Zusammenbau und der Verschweißung der Seitenwände 15 mit den Wandbereichen 10 der zu beiden Seiten angeordneten Abgaswärmetauscher 3 entsteht eine kompakte Einheit (siehe Fig. 12), deren frei bleibende Innenräume 19 ausgeschäumt werden können. Durch die thermische Entkoppelung der Seitenwände 15 vom Kühlmittelwärmetauscher 4 sind diese weitgehend isotherm. Diese Ausführungsform mit den beiden Abgaswärmetauschern 3 weist einen minimierten gasseitigen Wärmestromwiderstand auf und kann besonders vorteilhaft bei Dieselmotoren im Bereich der Abgasrückführstrecke und im Abgasbereich angewendet werden.

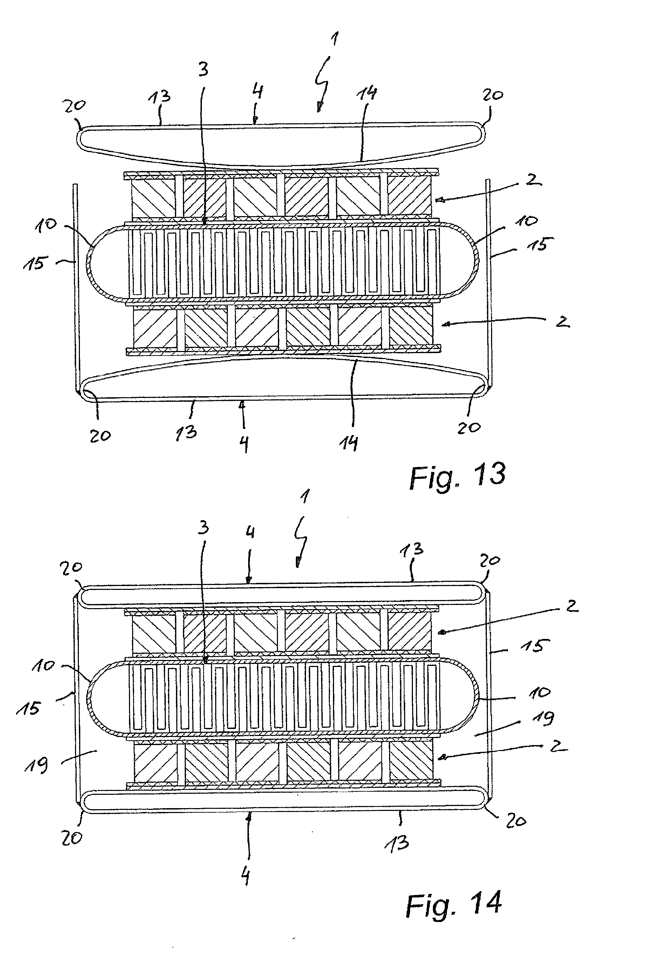

In den Fig. 13 und Fig. 14 ist eine Ausführungsvariante dargestellt, bei welcher die Seitenwände 15 einen Formschluss zwischen den seitlichen Wandabschnitten 20 zweier Kühlmittelwärmetauscher 4 bilden, die - unter Zwischenlage jeweils eines thermoelektrischen Moduls 2 - beiderseits eines Abgaswärmetauschers 3 angeordnet sind. Die seitlichen Wandabschnitte 10 des Abgaswärmetauschers 3 sind zu den Seitenwänden 15 thermisch entkoppelt, wodurch die Wärmeleitungsverluste über die weitgehend isothermen Seitenwände 15 minimiert werden.

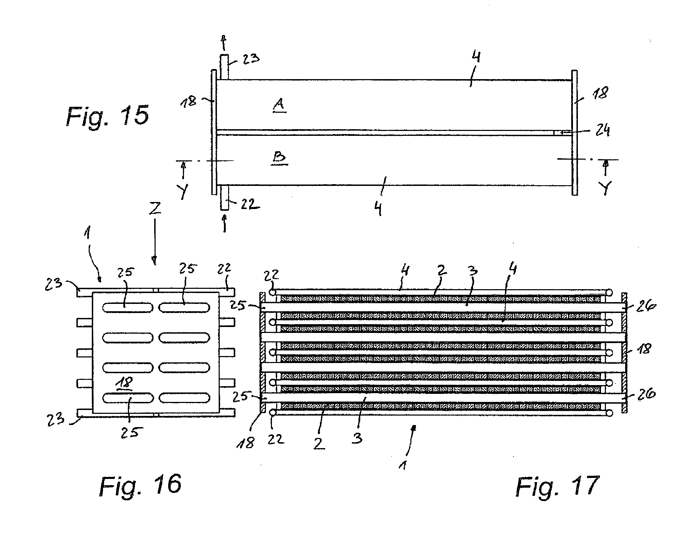

Schließlich ist in den Fig. 15 bis Fig. 17 eine leistungsstarke Ausführungsvariante dargestellt, bei der mehrere thermoelektrische Module 2, die jeweils von einem Abgaswärmetauscher 3 und einem Kühlmittelwärmetauscher 4 benachbart sind, in zwei Stapeln A und B sandwichartig zu einer thermoelektrischen Generatoreinheit 1 zusammengefasst sind.

Fig. 15 zeigt eine Draufsicht gemäß Pfeil Z in Fig. 16, Fig. 16 eine Stirnansicht und Fig. 17 eine Schnittdarstellung. Die Generatoreinheit 1 weist eine front- und eine rückseitige Stirnwand 18 auf, in welcher sich acht Gaseintritts- und Gasaustrittsöffnungen 25, 26 befinden, die mit den acht Abgaswärmetauschern 3 strömungsverbunden sind. Die zugeordneten Kühlmittelwärmetauscher 4, weisen jeweils einen seitlichen Kühlwassereinlass 22 sowie Kühlwasserauslass 23 auf, wobei zwischen den Stapeln A und B Kühlwasserüberleitungen 24 vorgesehen sind.

In allen Ausführungsvarianten sind die Flachrohre der Abgaswärmetauscher 3 und der Kühlmittelwärmetauscher 4 zur Realisierung von Gegenstrom- oder Gleichstromwärmetauschern 4 parallel angeordnet.

Durch die gekapselten Ausführungsvarianten der erfindungsgemäßen Generatoreinheiten können Korrosionsschäden weitgehend vermieden werden, wobei der geschlossene Innenraum 19 zur Minimierung der konvektiven Wärmeleitung mit einem Hochtemperaturschaum, beispielsweise mit einem Keramikschaum, ausgeschäumt werden kann. Es entsteht dadurch eine kompakte Generatoreinheit 1 mit allseits glatten, ebenen Oberflächen.

## Patentansprüche

1. Thermoelektrische Generatoreinheit (1), mit zumindest einem thermoelektrischen Modul (2), welches in einer sandwichartigen Anordnung an einer Seite einen Abgaswärmetauscher (3) und an der gegenüberliegenden Seite einen Kühlmittelwärmetauscher (4) aufweist, wobei der Abgas- und der Kühlmittelwärmetauscher (3, 4) als Flachrohre ausgeführt sind, deren Flachseiten (9, 13) jeweils über seitliche Wandabschnitte (10, 20) verbunden sind, dadurch **gekennzeichnet,** dass an den seitlichen Wandabschnitten (10, 20) zumindest der beiden außen liegenden Wärmetauscher (3, 4) Seitenwände (15) befestigt sind, die die Spannkräfte für eine gleichmäßige, dauerhafte Verpressung der einzelnen Elemente (2, 3, 4) der thermoelektrischen Generatoreinheit (1) aufnehmen.

2. Thermoelektrische Generatoreinheit (1) nach Anspruch 1, dadurch ge**kennzeichnet,** dass das zumindest eine thermoelektrische Modul (2) mittels der die Spannkräfte aufnehmenden Seitenwände (15) seitlich abgedichtet ist.

3. Thermoelektrische Generatoreinheit (1) nach Anspruch 1 oder 2, dadurch **gekennzeichnet,** dass an zumindest einer Kontaktfläche zwischen dem thermoelektrischen Modul (2) und dem Abgaswärmetauscher (3) oder dem Kühlmittelwärmetauscher (4) zumindest ein Federelement, beispielsweise ein Wellfederelement (33) oder ein Blattfederelement (34), angeordnet ist.

4. Thermoelektrische Generatoreinheit (1) nach Anspruch 1 oder 2, dadurch **gekennzeichnet,** dass zumindest eine der dem thermoelektrischen Modul (2) zugewandten Flachseiten (9, 13) des Abgaswärmetauschers (3) oder des Kühlmittelwärmetauschers (4) in Richtung des thermoelektrischen Moduls (2) elastisch vorgespannt ist.

5. Thermoelektrische Generatoreinheit (1) nach Anspruch 4, dadurch ge**kennzeichnet,** dass die elastisch vorgespannte Seite im unverbauten Zustand eine näherungsweise zylindrische Auswölbung (14) in Richtung des thermoelektrischen Moduls (2) aufweist, deren Kontur im verbauten Zustand flach gepresst ist.

6. Thermoelektrische Generatoreinheit (1) nach einem der Ansprüche 1 bis 5, dadurch **gekennzeichnet,** dass der Abgaswärmetauscher (3) und/oder der Kühlmittelwärmetauscher (4) Lamellen (11) zur Mäximierung des Wärmeübergangs und zur Versteifung der Flachrohre aufweist.

7. Thermoelektrische Generatoreinheit (1) nach einem der Ansprüche 1 bis 6, dadurch **gekennzeichnet,** dass zur Reibwertminderung und Verbesserung der thermischen Kontaktierung zwischen dem Abgaswärmetauscher (3) und dem thermoelektrischen Modul (2) eine Gleitschicht (16), beispielsweise eine Karbonfolie oder eine MoS₂-Beschichtung, vorgesehen ist.

8. Thermoelektrische Generatoreinheit (1) nach einem der Ansprüche 1 bis 7, dadurch **gekennzeichnet,** dass zur Verbesserung der thermischen Kontaktierung zwischen dem thermoelektrischen Modul (2) und dem Kühlmittelwärmetauscher (4) eine Kontaktschicht (17), beispielsweise eine DLC-Beschichtung, vorgesehen ist.

9. Thermoelektrische Generatoreinheit (1) nach einem der Ansprüche 3 bis 8, dadurch **gekennzeichnet,** dass in den vom Federelement (33, 34) aufgespannten Freiräumen (35) ein elastisches, wärmeleitendes Material, vorzugsweise eine Wärmeleitpasta, angeordnet ist.

10. Thermoelektrische Generatoreinheit (1) nach einem der Ansprüche 1 bis 9, dadurch **gekennzeichnet,** dass die Seitenwände (15) der thermoelektrischen Generatoreinheit (1) als Zugfedern (27) ausgebildet sind.

11. Thermoelektrische Generatoreinheit (1) nach einem der Ansprüche 1 bis 10, dadurch **gekennzeichnet,** dass die an dem Abgaswärmetauscher (3) und dem Kühlmittelwärmetauscher (4) befestigten Seitenwände (15) zusammen mit front- und rückseitigen Stirnwänden (18) der Generatoreinheit (1) einen bis auf die elektrischen Durchführungen (31) für das thermoelektrische Modul (2) geschlossenen Innenraum (19) bilden.

12. Thermoelektrische Generatoreinheit (1) nach Anspruch 11, dadurch ge**kennzeichnet,** dass der geschlossene Innenraum (19) zur Minimierung der konvektiven Wärmeleitung mit einem Hochtemperaturschaum, beispielsweise einen Keramikschaum, ausgeschäumt ist.

13. Thermoelektrische Generatoreinheit (1) nach einem der Ansprüche 1 bis 12, dadurch **gekennzeichnet,** dass die Seitenwände (15) durch Schweißen (21), Kleben, oder Löten, mit den seitlichen Wandabschnitten (10, 20) des Abgaswärmetauschers (3) und/oder des Kühlmittelwärmetauschers (4) verbunden sind.

14. Thermoelektrische Generatoreinheit (1) nach einem der Ansprüche 1 bis 12, dadurch **gekennzeichnet,** dass die Seitenwände (15) durch eine Niet-oder Schraubverbindung (36) mit den seitlichen Wandabschnitten (10, 20) des Abgaswärmetauschers (3) und/oder des Kühlmittelwärmetauschers (4) verbunden sind.

15. Thermoelektrische Generatoreinheit (1) nach einem der Ansprüche 1 bis 12, dadurch **gekennzeichnet,** dass die Seitenwände (15) durch eine Rast-oder Schnappverbindung (28) mit den seitlichen Wandabschnitten (10, 20) des Abgaswärmetauschers (3) und/oder des Kühlmittelwärmetauschers (4) verbunden sind.

16. Thermoelektrische Generatoreinheit (1) nach einem der Ansprüche 1 bis 15, dadurch **gekennzeichnet,** dass die Seitenwände (15) einen Formschluss zwischen den seitlichen Wandabschnitten (20) zweier Kühlmittelwärmetauscher (4) bilden, welche beiderseits eines Abgaswärmetauschers (3) angeordnet sind, dessen seitliche Wandabschnitte (10) zu den Seitenwänden (15) thermisch entkoppelt sind.

17. Thermoelektrische Generatoreinheit (1) nach einem der Ansprüche 1 bis 16, dadurch **gekennzeichnet,** dass mehrere thermoelektrische Module (2), die jeweils von einem Abgaswärmetauscher (3) und einem Kühlmittelwärmetauscher (4) benachbart sind, sandwichartig zu einer thermoelektrischen Generatoreinheit (1) zusammengefasst sind.

## Claims

1. Thermoelectric generator unit (1), with at least one thermoelectric module (2), which is provided with an exhaust gas heat exchanger (3) on one side and a coolant heat exchanger (4) on the opposite side in sandwich-like arrangement, said exhaust gas heat exchanger (3) and coolant heat exchanger (4) being designed as flat ducts whose flat sides (9, 13) are joined by lateral wall sections (10, 20), **characterised in that** side walls (15) are attached to the lateral wall sections (10, 20) of the two outer heat exchangers (3, 4) at least, which side walls (15) will sustain the clamping forces required for uniform and lasting pressing-together of the individual elements (2, 3, 4) of the thermoelectric generator unit (1).

2. Thermoelectric generator unit (1) according to claim 1, **characterised in that** the at least one thermoelectric module (2) is laterally sealed by the side walls (15) sustaining the clamping forces.

3. Thermoelectric generator unit (1) according to claim 1 or 2, **characterised in that** at least one spring element, for instance a corrugated spring element (33) or a leaf spring element (34), is provided on at least one contact surface between the thermoelectric module (2) and the exhaust gas heat exchanger (3) or the coolant heat exchanger (4).

4. Thermoelectric generator unit (1) according to claim 1 or 2, **characterised in that** at least one of the flat sides (9, 13) of the exhaust gas heat exchanger (3) or the coolant heat exchanger (4) facing the thermoelectric module (2) is elastically prestressed in the direction towards the thermoelectric module (2).

5. Thermoelectric generator unit (1) according to claim 4, **characterised in that** the elastically prestressed side has an approximately cylindrical bulge (14) in the direction of the thermoelectric module (2) prior to assembly, which bulge is pressed flat in the assembled state.

6. Thermoelectric generator unit (1) according to any of claims 1 to 5, **characterised in that** the exhaust gas heat exchanger (3) and/or the coolant heat exchanger (4) has lamellas (11) for maximizing heat transfer and increasing the stiffness of the flat ducts.

7. Thermoelectric generator unit (1) according to any of claims 1 to 6, **characterised in that** to reduce friction and to improve the thermal contact between the exhaust gas heat exchanger (3) and the thermoelectric module (2) an anti-friction layer (16) is provided, for instance a carbon film or MoS₂ coating.

8. Thermoelectric generator unit (1) according to any of claims 1 to 7, **characterised in that** to improve thermal contact between the thermoelectric module (2) and the coolant heat exchanger (4) a contact layer (17) is provided, for instance a DLC-coating.

9. Thermoelectric generator unit (1) according to any of claims 3 to 8, **characterised in that** an elastic, heat conducting material, preferably a heat conducting paste, is introduced into the empty spaces (35) defined by the spring elements (33, 34).

10. Thermoelectric generator unit (1) according to any of claims 1 to 9, **characterised in that** the side walls (15) of the thermoelectric generator unit (1) are configured as tension springs (27).

11. Thermoelectric generator unit (1) according to any of claims 1 to 10, **characterised in that** the side walls (15) attached to the exhaust gas heat exchanger (3) and to the coolant heat exchanger (4), together with the front and rear walls (18) of the generator unit (1) form an interior space (19) for the thermoelectric module (2), which is closed except for openings (31) for electrical leads.

12. Thermoelectric generator unit (1) according claim 11, **characterised in that** the enclosed interior space (19) is foam-filled with a high-temperature foam, for instance a ceramic foam, to minimize convective heat conduction.

13. Thermoelectric generator unit (1) according to any of claims 1 to 12, **characterised in that** the side walls (15) are attached to the lateral wall sections (10, 20) of the exhaust gas heat exchanger (3) and/or the coolant heat exchanger (4) by means of welding (21), soldering or bonding.

14. Thermoelectric generator unit (1) according to any of claims 1 to 12, **characterised in that** the side walls (15) are attached to the lateral wall sections (10, 20) of the exhaust gas heat exchanger (3) and/or the coolant heat exchanger (4) by means of rivets or screws (36).

15. Thermoelectric generator unit (1) according to any of claims 1 to 12, **characterised in that** the side walls (15) are attached to the lateral wall sections (10, 20) of the exhaust gas heat exchanger (3) and/or the coolant heat exchanger (4) by means of a snap-on connection (28).

16. Thermoelectric generator unit (1) according to any of claims 1 to 15, **characterised in that** the side walls (15) form a positive-locking connection between the lateral wall sections (20) of two coolant heat exchangers (4), which are placed on either side of an exhaust gas heat exchanger (3), whose lateral wall sections (10) are thermally decoupled from the side walls (15).

17. Thermoelectric generator unit (1) according to any of claims 1 to 16, **characterised in that** a plurality of thermoelectric modules (2), each of which is adjacent to an exhaust gas heat exchanger (3) and a coolant heat exchanger (4), are combined sandwich-like to form a thermoelectric generator unit (1).

## Revendications

1. Unité de générateur thermoélectrique (1), comprenant au moins un module thermoélectrique (2) monté en sandwich entre une face d'un échangeur de chaleur de gaz d'échappement (3) et la face opposée d'un échangeur de chaleur de fluide de refroidissement (4), les échangeurs de chaleur de gaz d'échappement et de fluide de refroidissement (3, 4) étant réalisés sous la forme de tubes plats dont les faces planes (9, 13) sont respectivement reliées par des segments de parois latéraux (10, 20),
**caractérisée en ce que**
sur les segments de parois latéraux (10, 20) d'au moins les deux échangeurs de chaleur (3, 4) externes sont fixées des parois latérales (15) qui recueillent les efforts de serrage pour permettre la compression permanente uniforme des différents éléments (2, 3, 4) de l'unité de générateur thermoélectrique (1).

2. Unité de générateur thermoélectrique (1) conforme à la revendication 1,
**caractérisée en ce que**
le module thermoélectrique (2) est rendu étanche latéralement au moyen des parois latérales (15) recueillant les efforts de serrage.

3. Unité de générateur thermoélectrique (1) conforme à la revendication 1 ou 2,
**caractérisée en ce que**
sur au moins une face de contact entre le module thermoélectrique (2) et l'échangeur de chaleur de gaz d'échappement (3) ou l'échangeur de chaleur de fluide de refroidissement (4) est monté au moins un élément élastique, par exemple un élément à ressort ondulé (33) ou un élément à ressort lame (34).

4. Unité de générateur thermoélectrique (1) conforme à la revendication 1 ou 2,
**caractérisée en ce qu'**
au moins l'une des faces planes (9, 13) de l'échangeur de chaleur de gaz d'échappement (3) ou de l'échangeur de chaleur de fluide de refroidissement (4) tournée vers le module thermoélectrique (2) est précontrainte élastiquement en direction du module thermoélectrique (2).

5. Unité de générateur thermoélectrique (1) conforme à la revendication 4,
**caractérisée en ce que**
la face précontrainte élastiquement comporte à l'état non monté un cintrage (14) essentiellement cylindrique en direction du module thermoélectrique (2) dont le contour est comprimé à plat à l'état monté.

6. Unité de générateur thermoélectrique (1) conforme à l'une des revendications 1 à 5,
**caractérisée en ce que**
l'échangeur de chaleur de gaz d'échappement (3) et/ou l'échangeur de chaleur de fluide de refroidissement (4) comporte(nt) des lamelles (11) pour permettre d'augmenter au maximum le transfert de chaleur et de rigidifier les tubes plats.

7. Unité de générateur thermoélectrique (1) conforme à l'une des revendications 1 à 6,
**caractérisée en ce que**
pour diminuer le coefficient de friction et améliorer le contact thermique entre l'échangeur de chaleur de gaz d'échappement (3) et le module thermoélectrique (2) il est prévu une couche de glissement (16) par exemple un film de carbone ou un revêtement en MoS₂.

8. Unité de générateur thermoélectrique (1) conforme à l'une des revendications 1 à 7,
**caractérisée en ce que**
pour améliorer le contact thermique entre le module thermoélectrique (2) et l'échangeur de chaleur de fluide de refroidissement (4) il est prévu une couche de contact (17) par exemple un revêtement DLC.

9. Unité de générateur thermoélectrique (1) conforme à l'une des revendications 3 à 8,
**caractérisée en ce que**
les espaces libres (35) mis sous contrainte par l'élément à ressort (33, 34) renferment un matériau élastique thermiquement conducteur de préférence une pate thermiquement conductrice.

10. Unité de générateur thermoélectrique (1) conforme à l'une des revendications 1 à 9,
**caractérisée en ce que**
les parois latérales (15) de l'unité de générateur thermoélectrique (1) sont réalisées sous la forme de ressorts de traction (27).

11. Unité de générateur thermoélectrique (1) conforme à l'une des revendications 1 à 10,
**caractérisée en ce que**
les parois latérales (15) fixées à l'échangeur de chaleur de gaz d'échappement (3) et à l'échangeur de chaleur de fluide de refroidissement (4) forment, avec des parois frontales avant et arrière (18) de l'unité de générateur (1) un volume interne (19) fermé jusqu'aux passages électriques (31) pour le module thermoélectrique (2).

12. Unité de générateur thermoélectrique (1) conforme à la revendication 11,
**caractérisée en ce que**
pour réduire au maximum le transfert de chaleur par convection, le volume interne fermé (19) est expansé avec une mousse haute température, par exemple une mousse céramique.

13. Unité de générateur thermoélectrique (1) conforme à l'une des revendications 1 à 12,
**caractérisée en ce que**
les parois latérales (15) sont reliées aux segments de parois latéraux (10, 20) de l'échangeur de chaleur de gaz d'échappement (3) et/ou de l'échangeur de chaleur de fluide de refroidissement (4) par soudure (21) colle ou brasage.

14. Unité de générateur thermoélectrique (1) conforme à l'une des revendications 1 à 12,
**caractérisée en ce que**
les parois latérales (15) sont reliées aux segments de parois latéraux (10, 20) de l'échangeur de chaleur de gaz d'échappement (3) et/ou de l'échangeur de chaleur de fluide de refroidissement (4) par une liaison par rivetage ou vissage (36).

15. Unité de générateur thermoélectrique (1) conforme à l'une des revendications 1 à 12,
**caractérisée en ce que**
les parois latérales (15) sont reliées aux segments de parois latéraux (10, 20) de l'échangeur de chaleur de gaz d'échappement (3) et/ou de l'échangeur de chaleur de fluide de refroidissement (4) par une liaison par encliquetage ou à déclic (28).

16. Unité de générateur thermoélectrique (1) conforme à l'une des revendications 1 à 15,
**caractérisée en ce que**
les parois latérales (15) forment une liaison par la forme entre les segments de parois latéraux (20) de deux échangeurs de chaleur de fluide de refroidissement (4) qui sont situés de part et d'autre d'un échangeur de chaleur de gaz d'échappement (3) dont les segments de parois latéraux (10) sont thermiquement découplés des parois latérales (15).

17. Unité de générateur thermoélectrique (1) conforme à l'une des revendications 1 à 16,
**caractérisée en ce que**
plusieurs modules thermoélectriques (2) qui sont respectivement voisins d'un échangeur de chaleur de gaz d'échappement (3) et d'un échangeur de chaleur de fluide de refroidissement (4) sont rassemblés et montés en sandwich pour former une unité de générateur thermoélectrique (1).
